Europäisches Patentamt

European Patent Office

Office européen des brevets

(19)

(11) **EP 0 846 955 A1**

(12) **EUROPEAN PATENT APPLICATION**

(43) Date of publication:
**10.06.1998 Bulletin 1998/24**

(51) Int. Cl.$^6$: **G01R 31/28**

(21) Application number: **96402633.0**

(22) Date of filing: **05.12.1996**

(84) Designated Contracting States:
**DE FR GB**

(71) Applicant:
**MOTOROLA SEMICONDUCTEURS S.A.**
**F-31023 Toulouse Cédex (FR)**

(72) Inventor: **Perraud, Eric**
**31170 Tournefeuille (FR)**

(54) **Sensor test arrangement and method**

(57)   A first input voltage is applied to the input of a sensor (110), and a first output voltage is measured at the output (161). A second input voltage is then applied to the input of the sensor (110) , and a second output voltage is measured. Then the first and the second output voltages are compared to determine whether a predetermined relationship exists between them.

FIG.2

# EP 0 846 955 A1

**Description**

<u>Field of the Invention</u>

This invention relates generally to the testing of sensors, and particularly but not exclusively to testing of silicon sensors.

<u>Background of the Invention</u>

Sensors are being used more and more in conjunction with electronic equipment, and silicon sensors are tending towards greater integration with integrated circuits. Pressure sensor manufacturers now offer sensors with on-chip signal conditioning. For example, in automotive electronic applications "Smart" sensors are now incorporated in multiplexed systems, where different sensors are connected to a bus or local network, and these sensors are arranged to send sensed data to the bus in response to received instructions.

A problem with such sensors is the difficulty in detecting a malfunction of the sensor, and this is particularly acute in safety systems (such as with an airbag arrangement). Diagnostic equipment is known which can test a sensor.

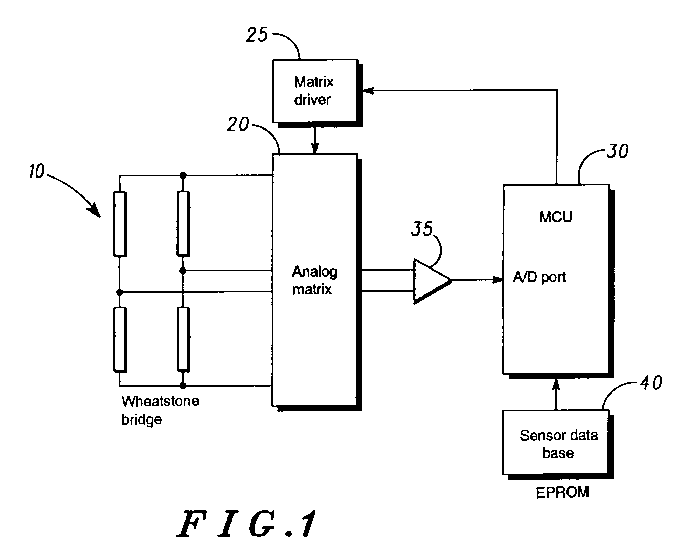

Referring to FIG.1, there is shown a typical prior art arrangement for testing a sensor using a Wheatstone bridge 10. The arrangement includes a voltage supply unit with an analogue switch matrix 20, connected to an MCU 30 via a matrix driver circuit 25.

The Wheatstone bridge 10 is coupled to the analogue switch matrix 20, which contains different resistances and analogue switches. The MCU 30 controls the different configurations of this matrix by sending signals to the matrix driver circuit 25. According to what the user wants to test, a specific stimulus (test) will be applied to the Wheatstone bridge, or to elements thereof. Each stimulus (or test configuration) gives a resulting signal from the sensor, which is provided back to the MCU 30 via an analogue-to-digital converter 35. The results, and previous results if required, are stored in a sensor database comprising an EPROM 40.

By way of example, if the user wants to check that there is no short or open circuit on the supply voltage, the analogue switch matrix 20 is arranged to link 2 series resistors with the bridge supply voltage leads. The MCU 30 reads the current requirement of the Wheatstone bridge circuit 10, and reads the nominal current requirement stored in the database; it is then able to identify if an open circuit or a short circuit has occurred in the sensor, by comparing the measured current value with the stored value.

In another example, if the user wants to check whether the Wheatstone bridge 10 arrangement is broken or not, the analogue matrix switches are arranged so that a common mode voltage is sensed.

A problem with this arrangement is that an analogue matrix is required with many analogue switches and resistors. In addition, it requires many circuits for signal conditioning and many MCU input/outputs to drive the analogue switch matrix.

This invention seeks to provide a sensor test arrangement and method which mitigates the above mentioned disadvantages.

<u>Summary of the Invention</u>

According to a first aspect of the present invention there is provided a sensor test arrangement comprising: first and second switched resistors, coupled for providing first and second voltages to a sensor to be tested; control means coupled to provide control signals to the first and second switched resistors, and further coupled for receiving output signals from the sensor to be tested; and, a memory for storing sensor test data; wherein the control means is arranged to test the sensor by monitoring the output signals when each of the first and second voltages are applied to the sensor, and for comparing the received signals with the sensor test data.

Preferably the arrangement further comprises a third switched resistor, the third switched resistor being arranged to provide a third voltage equivalent to a maximum non-destructive overload condition; wherein the control means is arranged to compare the output signal responsive to the third voltage with a predetermined value, to determine whether the sensor is in a destructive or non-destructive overload condition.

According to a second aspect of the present invention, there is provided a method of testing a sensor having an input and an output, comprising the steps of: applying a first input voltage to the input of the sensor; measuring a first output voltage at the output of the sensor, responsive to the first input voltage; applying a second input voltage to the input of the sensor; measuring a second output voltage at the output of the sensor, responsive to the second voltage; comparing the first and the second output voltages to determine whether a predetermined relationship exists therebetween.

Preferably the method further comprises the steps of: applying a third voltage to the input of the sensor, the third voltage being equivalent to a maximum non-destructive overload condition; measuring a third output voltage at the out-

2

put of the sensor; and, comparing the third output voltage with a predetermined value. Preferably the sensor is a piezo-resistive sensor.

In this way, a sensor test arrangement and method is provided without the need for a large analogue matrix, and without the need for many circuits for signal conditioning and many MCU input/outputs.

## Brief Description of the Drawing(s)

An exemplary embodiment of the invention will now be described with reference to the drawings in which:

FIG.1 shows a diagram of a prior art sensor arrangement.

FIG.2 shows a preferred embodiment of a sensor arrangement in accordance with the invention.

FIG.3 shows a flow chart of a sensor test method using the sensor arrangement of FIG.2.

## Detailed Description of a Preferred Embodiment

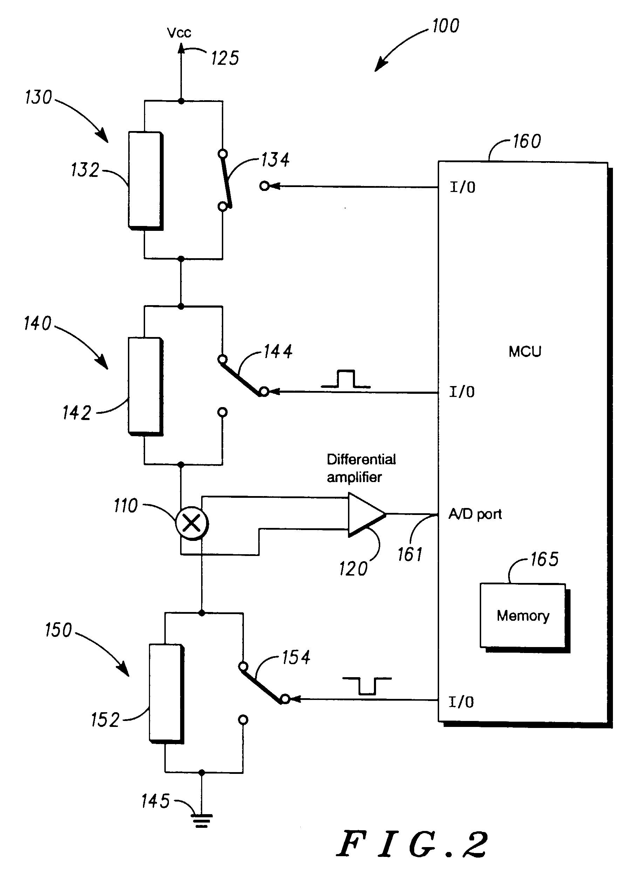

Referring to FIG.2, there is shown a sensor test circuit 100, for testing an uncompensated or a compensated pressure sensor 110. The sensor 110 has four terminals. First and third terminals are coupled to two inputs of a differential amplifier 120. A second terminal is coupled to a supply voltage terminal 125 via first and second resistor networks 130 and 140 respectively. A fourth terminal of the sensor 110 is coupled to a ground terminal 145 via a third resistor network 150.

The first resistor network 130 comprises a resistor 132, having a resistance R0, in parallel with a switch 134. Thus when the switch 134 is open, the resistor 132 provides a resistance of R0 between the second resistor network 140 and the supply voltage terminal 125. When the switch 134 is closed, the resistor 132 is shorted, resulting in a negligible resistance between the second resistor network 140 and the supply voltage terminal 125.

Similarly, the second resistor network 140 comprises a resistor 142, having a resistance R1, in parallel with a switch 144. When the switch 144 is open, there is a resistance of R1 between the second terminal of the sensor 110 and the first resistor network 130. When the switch 144 is closed, there is negligible resistance between the second terminal of the sensor 110 and the first resistor network 130.

The third resistor network 150 comprises a resistor 152, having a resistance R2, in parallel with a switch 154. When the switch 154 is open, there is a resistance of R2 between the fourth terminal of the sensor 110 and the ground terminal 145. When the switch 144 is closed, there is negligible resistance between the fourth terminal of the sensor 110 and the ground terminal 145.

R1 and R2 are approximately the same typical value and are arranged such that $R=R1+R2$ equals the typical input impedance of the sensor 110.

A microcontroller (MCU) 160 has an analogue-to-digital port (A/Dport) 161 coupled to receive an output signal from the differential amplifier 120. The MCU 160 is further coupled to provide control signals to control the switches 134, 144 and 154. The MCU 160 includes a memory 165. The control signals to switches 144 and 154 are arranged such that they are synchronised: they are closed or opened substantially together.

The output of the sensor after signal conditioning, Vout, is given by:-

$$Vout = G\ Vin + V0 \tag{1}$$

where Vin is the sensor output, G is the gain of the sensor, and V0 is an additional voltage which is caused by op amps offset, by residual sensor common mode and possibly by an analogue voltage (used for offset compensation). Vin is ratiometric with (that is, proportional to) the sensor excitation voltage, and V0 is substantially independent of the supply voltage.

If switches 144 and 154 are opened, the sensor 110 excitation voltage is given by a*Vcc, where $a = Zin/(Zin+R1+R2)$, and Zin is the input impedance of the sensor 110.

If they are closed, R1 and R2 are removed from the equation, and the sensor 110 excitation voltage is simply Vcc - voltage drop in switches 144 and 154. The switches 144 and 154 may be bipolar transistors or CMOS transistors. With bipolar technology, switch 144 would be a PNP transistor, and switch 154 would be a NPN transistor. Then the excitation voltage with switches 144 and 154 closed would be given by:

$$Vcc' = Vcc - V_{CE}\text{switch } 144 - V_{CE}\text{switch } 154$$

In CMOS technology, switch 144 would be a CMOS P channel transistor and switch 154 would be a CMOS N channel transistor, and the excitation voltage would be given by:

$$Vcc' = Vcc -(RDswitch\ 144 + RDswitch\ 154)^* \ Isensor$$

where RD is the inherent resistance of the relevant switch.

The switches 144 and 154 are driven by two complementary logical signals coming directly from the MCU 160 with CMOS transistors or through biasing resistors with bipolar transistors. For an open switch configuration, the switch 144 driving signal is high and the switch 154 driving signal is low. For closed switches, these driving signals are inverted. They can be either two digital outputs of the MCU 160, or they can come from the same digital MCU output, with the complementary signal being formed with an inverter gate.

Considering equation (1) in the two cases where the switches are both open or both closed, the term "G*Vin" differs by the factor "a", the resistance factor, since V0 does not change in the switch positions. V0 is known by calibration, when the sensor 110 is manufactured. A further coefficient b is defined as:-

$$b = Vcc'/(\ a^*Vcc) \tag{2}$$

This coefficient is also known by calibration, and defines a ratiometric relationship between the two switch configurations. V0 and b are stored in the memory 165 of the MCU 160 when the sensor 110 is manufactured and assembled.

In operation, the sensor 110 may malfunction due to one or more faults. If any of the sensor connections are broken, or if the sensor is damaged, the sensor 110 will no longer exhibit a ratiometric relationship according to coefficient b.

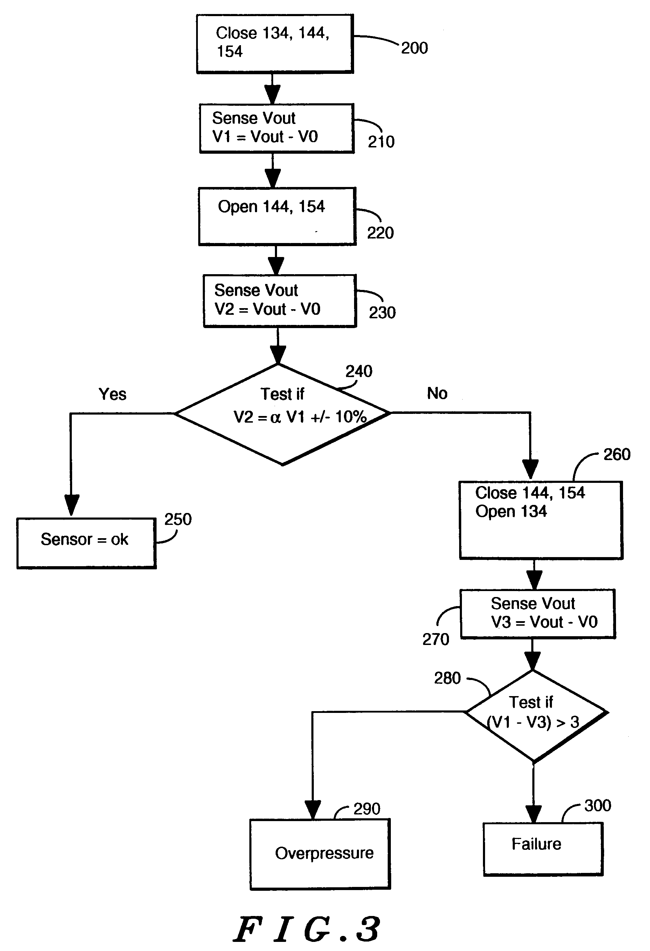

The following test routine, controlled by the MCU 160, is able to determine whether ratiometricity has been lost. The following steps are shown in FIG.3.

a). Close switch 144 and switch 154 (step 200).

$$\left.\begin{array}{ll} b). & \text{Sense output voltage, Vout1} \\ c). & \text{Compute Vout1' = Vout1 - V0} \end{array}\right\} \text{(step 210).}$$

d). Open switch 144 and switch 154 (step 220).

$$\left.\begin{array}{ll} e). & \text{Sense output voltage, Vout2} \\ f). & \text{Compute Vout2' = Vout2 - V0} \end{array}\right\} \text{(step 230)}$$

g). Correct a with temperature (and b)

h).

Compute guard band :  - Vmax = Vout2'/(0,9*b)
                       - Vmin = Vout2'/(1,1*b)

The guard band provides an error tolerance to the test

i). Test if Vout1' is between Vmax and Vmin (step 240).

If the result of test i) is yes, then sensor 110 is exhibiting ratiometricity, and has tested successfully (step 250), completing the test routine.

If the result of test i) is no, then the sensor may be damaged. However, it is possible that the sensor is still able to function correctly, but that it is subject to overpressure. The functionality of the sensor in this situation depends on whether the pressure being applied to the sensor 110 is higher than the maximum pressure specified which does not damage the sensor 110. This non-destructive overpressure would still result in a failure when performing test i) above.

Therefore a further test is conducted, using the first resistor network 130. With switch 134 open, and switches 144 and 154 closed, the sensor 110 excitation voltage is given by:

$$Vcc * Zin / (Zin+ R0) = g*Vcc$$

The value R0 of the first resistor 132 is chosen such that the following is true:

$$g = Pover/Pmax,$$

where Pover is the maximum specified overpressure which may be applied without causing a permanent change in the output characteristics and Pmax is the pressure range the sensor has been designed for. The excitation voltage of the bridge, Vex, will be greatly reduced and so will the sensing element output. Then if pressure is higher than Pmax but lower than Pover, the sensor output will not saturate the differential amplifier 120 nor the A/D port 161 of the MCU 160. If however the differential amplifier 120 or the A/D port 161 are still saturated, the pressure is higher than Pover; and therefore the sensing element may have lost its elastic properties. In this case, for reliability and accuracy reasons, it would be recommended to replace the sensor.

A second test is performed, using the first resistor network 134, according to the following steps (see Fig. 3):

j). Close switch 144, switch 154 and open switch 134 (step 260).
k). Read output voltage, Vout0 (step 270).
l). Test if Vout1 - Vout0 > 3 (step 280).

If the result of test l) is yes, then sensor 110 is subject to non-destructive overpressure, and can still be used (step 290).

If the result of test l) is no, then the sensor may have been subject to critical overpressure, and may be permanently damaged (step 300).

In this way the sensor 110 can be easily and simply tested to determine a critical failure and a non-critical overpressure condition. The circuitry required to perform the tests is minimal: the MCU 160 requires a number of digital outputs to drive the switches, and one A/D port for the differential amplifier 120 output. The external circuitry is very simple (three resistors and three transistors) and inexpensive; the software routine is also very simple.

The above test routine (ratiometric test) and subroutine (overpressure test) may be performed at system start-up, at fixed periods, or whenever requested by a user.

It will be appreciated that alternative embodiments to the one described above are possible. For example, in the above embodiment with an uncompensated sensor, R1 and R2 may be around 220 ohms because the input impedance Zin is typically 440 ohms for such a sensor. With these values, b is close to 2, However, other resistances could be chosen.

## Claims

1. A sensor test arrangement comprising:

   first (132) and second (142) switched resistors, coupled for providing first and second voltages to a sensor (110) to be tested;
   control means (160) coupled to provide control signals to the first and second switched resistors, and further coupled for receiving output signals from the sensor to be tested; and,
   a memory (165) for storing sensor test data;
   wherein the control means (160) is arranged to test the sensor (110) by monitoring the output signals when each of the first and second voltages are applied to the sensor, and for comparing the received signals with stored sensor test data.

2. The arrangement of claim 1, further comprising a third switched resistor, the third switched resistor (152) being arranged to provide a third voltage equivalent to a maximum non-destructive overload condition;
   wherein the control means (160) is arranged to compare the output signal responsive to the third voltage with a predetermined value, to determine whether the sensor is in a destructive or non-destructive overload condition.

3. A method of testing a sensor (110) having an input and an output, comprising the steps of:

applying a first input voltage to the input of the sensor (step 200);

measuring a first output voltage at the output of the sensor, responsive to the first input voltage (step 210);

applying a second input voltage to the input of the sensor (step 220);

measuring a second output voltage at the output of the sensor, responsive to the second voltage (step 230);

comparing the first and the second output voltages to determine whether a predetermined relationship exists therebetween (step 240).

4.  The method of claim 3, further comprising the steps of:

applying a third voltage to the input of the sensor (step 260), the third voltage being equivalent to a maximum non-destructive overload condition;

measuring a third output voltage at the output of the sensor (step 270); and,

comparing the third output voltage with a predetermined value (step 280).

5.  The method or arrangement of any preceding claim, wherein the sensor is a piezo-resistive sensor.

30

MCU

A/D port

40

Sensor data base

EPROM

35

25

Matrix driver

20

Analog matrix

10

Wheatstone bridge

*F I G . 1*

*FIG.2*

```
           ┌─────────────────┐
           │  Close 134, 144,│
           │      154        │────╮ 200
           └────────┬────────┘
                    │
                    ▼
           ┌─────────────────┐
           │   Sense Vout    │
           │ V1 = Vout - V0  │──╮ 210
           └────────┬────────┘
                    │
                    ▼
           ┌─────────────────┐
           │  Open 144, 154  │
           │                 │──╮ 220
           └────────┬────────┘
                    │
                    ▼
           ┌─────────────────┐
           │   Sense Vout    │
           │ V2 = Vout - V0  │──╮ 230
           └────────┬────────┘
                    │
                    ▼
                   240
                  ╱◇╲
     Yes         ╱    ╲         No
  ◀────────────◇ Test if ◇────────────▶
              ╲ V2 = α V1 +/- 10% ╱
                ╲    ╱                        260
                 ╲◇╱                   ┌──────────────┐
                                       │ Close 144, 154│──╮
      ┌──────────────┐                 │  Open 134    │
 250  │  Sensor = ok │                 └──────┬───────┘
      └──────────────┘                        │
                                              ▼
                                       ┌──────────────┐
                                   270 │  Sense Vout  │
                                       │ V3 = Vout - V0│
                                       └──────┬───────┘
                                              │
                                 280          ▼
                                             ╱◇╲
                                            ╱    ╲
                              ◀────────────◇ Test if ◇
                                           ╲(V1-V3)>3╱
                                            ╲    ╱
                                             ╲◇╱
          ┌──────────────┐           ┌──────────────┐
      290 │ Overpressure │           │   Failure    │ 300
          └──────────────┘           └──────────────┘
```

$$V2 = \alpha\ V1\ +/-\ 10\%$$

$$(V1 - V3) > 3$$

*F I G . 3*

9

European Patent Office

**EUROPEAN SEARCH REPORT**

Application Number

EP 96 40 2633

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | WO 96 07562 A (BOSCH)<br>* page 4, line 20 - page 7, line 30; figure 1 *<br>--- | 1,3 | G01R31/28 |
| A | EP 0 701 928 A (FORD)<br>* figure 1 *<br>--- | 1 | |
| A | DE 44 13 194 A (MITSUBISHI)<br>* claim 1 *<br>--- | 1 | |
| A | US 4 835 513 A (MCCURDY)<br>* figure 2 *<br>----- | 1 | |
| | | | TECHNICAL FIELDS SEARCHED (Int.Cl.6)<br><br>G01R |

The present search report has been drawn up for all claims

| Place of search | Date of completion of the search | Examiner |
|---|---|---|
| THE HAGUE | 25 April 1997 | Hoornaert, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)